# FASCICULE DE BREVET EUROPEEN

(11) **EP 2 770 810 B1**
(45) Date de publication et mention de la délivrance du brevet: **18.10.2017**
(21) Numéro de dépôt: 14154689.5
(22) Date de dépôt: 11.02.2014
(51) Int. Cl.: H05K 7/20

(54) **Carte électronique pourvue d'un système de refroidissement liquide**
Elektronische Karte, die mit einem Flüssigkeitskühlsystem versehen ist
Electronic card provided with a liquid cooling system

(30) Priorité: 20.02.2013 FR 1351424
(43) Date de publication de la demande: 27.08.2014
(73) Titulaire: BULL SAS, 78340 Les Clayes sous Bois (FR)
(72) Inventeur: Demange, Fabien, 78300 Poissy (FR); Dallaserra, Luc, 75009 Paris (FR); Guilbault, Pascal, 92160 Antony (FR)
(74) Mandataire: Camus, Olivier Jean-Claude

(56) Documents cités:
- WO-A2-2009/143330
- DE-A1- 4 012 100
- US-A- 4 155 402
- US-A1- 2004 190 255
- US-A1- 2007 206 361

## Description

### DOMAINE TECHNIQUE

La présente invention concerne une carte électronique pourvue d'un système de refroidissement liquide, notamment pour serveur montable sur bâti. La présente invention concerne également un serveur montable sur bâti pourvu d'une telle carte électronique, ainsi qu'un bâti comportant un tel serveur.

### ETAT DE LA TECHNIQUE ANTERIEURE

Les lames de calcul pour serveur comportent généralement des cartes électroniques qui dégagent de la chaleur et doivent donc être refroidies. Initialement, ces cartes électroniques étaient refroidis par de l'air. Toutefois, dans le cas des serveurs montables sur bâti, la circulation d'air n'est pas suffisante pour refroidir les cartes électroniques.

Pour résoudre ce problème, des systèmes de refroidissement fluidiques ont été développés. Ces systèmes de refroidissement comportent généralement autant de plaques froides que de composants à refroidir. Ainsi, au-dessus de chaque composant électronique à refroidir, les systèmes de refroidissement de l'art antérieur comportent une plaque froide, c'est-à-dire une petite plaque, généralement en cuivre, qui présente des dimensions sensiblement égales à celles du composant à refroidir, et qui est parcourue par des canaux dans lesquels circule un fluide caloporteur. Les différentes plaques froides sont généralement reliées entre elles par des canaux en cuivre qui permettent de faire circuler le fluide caloporteur d'une plaque froide à l'autre. Toutefois de tels systèmes de refroidissement sont complexes. En outre, les tubes de cuivre sont généralement fixés par brasage sur les plaques froides et par conséquent, il existe un risque de fuite.

US 4 155 402 divulgue une carte électronique comportant un support sur laquelle sont fixés des composants électroniques, les composants électroniques présentant une hauteur inférieure à une première hauteur seuil h1 ; est une plaque froide qui s'étend parallèlement au support, la distance entre la plaque froide et le support étant égale à la première hauteur seuil h1, la plaque froide comportant une plaque de base dans laquelle est creusé au moins un canal apte à être parcouru par un fluide caloporteur, la plaque de base étant solidaire d'une plaque complémentaire fermant le canal, la plaque froide recouvre tous les composants électroniques, les composants électroniques étant reliés à la plaque froide par l'intermédiaire de coussinets déformables en matériau conducteur thermiquement.

### EXPOSE DE L'INVENTION

L'invention vise à remédier aux inconvénients de l'état de la technique en proposant un dispositif de refroidissement d'une carte électronique, notamment pour serveur montable sur bâti, qui soit simple à mettre en oeuvre, qui soit compact, y compris lorsque la carte électronique comporte des composants électroniques de tailles différentes, et qui soit fiable.

Pour ce faire, est proposé selon un premier aspect de l'invention, une carte électronique, comportant :
- un support sur laquelle sont fixés des composants électroniques dits « composants électroniques bas », les composants électroniques bas présentant une hauteur inférieure à une première hauteur seuil h1 ;
- une plaque froide qui s'étend parallèlement au support, la distance entre la plaque froide et le support étant égale à la première hauteur seuil h1, la plaque froide comportant une plaque de base dans laquelle est creusé au moins un canal apte à être parcouru par un fluide caloporteur, la plaque de base étant solidaire d'une plaque complémentaire fermant le canal, la plaque froide recouvrant tous les composants électroniques bas, les composants électroniques bas étant reliés à la plaque froide par l'intermédiaire de coussinets déformables en matériau conducteur thermiquement.

Ainsi, le système de refroidissement selon l'invention est plus simple que les systèmes de l'art antérieur, puisqu'à l'aide d'une seule plaque froide dans laquelle est creusé un canal apte à être parcouru par un fluide caloporteur, on peut refroidir non seulement l'ensemble des composants électroniques bas, mais également l'ensemble du support sur lequel se trouvent ses composants, ce qui n'était pas le cas dans l'art antérieur. En outre, ce système de refroidissement présente une fiabilité améliorée et un risque de fuite limité car il ne nécessite pas de raccords entre différentes plaques froides et le canal est entièrement inclus dans la plaque froide. Ce système de refroidissement est en outre plus efficace puisque tous les composants électroniques sont refroidis, y compris les plus petits, pour lesquels il n'était pas forcément prévu de plaque froide spécifique dans l'art antérieur. Par ailleurs, le canal étant creusé dans la plaque froide, la géométrie, les dimensions, et la densité du réseau hydraulique formé par le canal sont choisies en fonction de la chaleur dégagée par les composants électroniques et en fonction du nombre et de la position des composants électroniques. Par ailleurs, le refroidissement des composants électroniques est optimisé grâce à la présence des coussinets déformables en matériau conducteur thermiquement dont l'épaisseur est un des paramètres d'optimisation en performance.

La carte électronique selon l'invention peut également présenter une ou plusieurs des caractéristiques ci-après prises individuellement ou selon toutes les combinaisons techniquement possibles.

La plaque froide présente de préférence des dimensions extérieures égales ou sensiblement égales à celles du support, si l'on ne tient pas compte des ouvertures traversantes comme on le verra dans la suite, ce qui permet à la plaque froide de recouvrir l'ensemble du support et donc de refroidir l'ensemble du support.

La carte électronique peut comporter des composants électroniques de différentes hauteur. Ainsi, outre les composants électroniques dits « composants électroniques bas », qui présentent une hauteur inférieure à la première hauteur seuil h1, la carte électronique peut comporter des composants électroniques dits « composants électroniques moyens » fixés sur le support, qui présentent une hauteur comprise entre la première hauteur seuil h1 et une deuxième hauteur seuil h2 supérieure à h1.

Dans ce cas, la plaque froide est de préférence percée par des ouvertures non traversantes dans lesquelles sont insérées les composants électroniques moyens de façon à ce que la plaque froide recouvre tous les composants électroniques moyens, les composants électroniques moyens étant reliés à la plaque froide par l'intermédiaire de coussinets déformables en matériau conducteur thermiquement. Ces ouvertures non traversantes permettent à la plaque froide de recouvrir les composants électroniques moyens de façon à les refroidir.

L'épaisseur de la plaque froide est de préférence égale à h2-h1.

La carte électronique peut également comporter des composants électroniques dits « composants électroniques hauts », les composants électroniques hauts étant fixés sur le support, les composants électroniques hauts présentant une hauteur supérieure à la deuxième hauteur seuil h2.

Dans ce cas, la plaque froide est de préférence percée par des ouvertures traversantes dans lesquelles sont insérés les composants électroniques hauts. Ces ouvertures traversantes permettent d'utiliser une seule plaque froide qui recouvre tout le support, à l'exception des composants électroniques hauts. En outre, ces ouvertures traversantes permettent d'avoir accès aux composants électroniques hauts, malgré la présence de la plaque froide, par exemple pour les changer ou pour les réparer.

Les composants électroniques hauts peuvent être des processeurs et/ou des barrettes mémoires.

La carte électronique peut en outre comporter des dissipateurs de chaleurs additionnels reliant thermiquement les composants électroniques hauts et la plaque froide de façon à évacuer la chaleur issue des composants électroniques hauts. Les dissipateurs de chaleurs additionnels sont de préférence reliés à la plaque froide par l'intermédiaire de coussinets déformables en matériau conducteur thermiquement. En effet, la plaque froide comportant des ouvertures traversantes en face des composants électroniques hauts, ces composants électroniques hauts ne sont pas directement refroidis par la plaque froide et par conséquent, il est avantageux d'utiliser les dissipateurs de chaleurs additionnels qui permettent de relier thermiquement ces composants électroniques hauts à la plaque froide de façon à évacuer la chaleur de ces composants électroniques hauts. Les dissipateurs de chaleurs additionnels sont de préférence réalisés en cuivre.

Les composants électroniques sont de préférence regroupés par taille sur le support de façon à simplifier la conception de la plaque froide : ainsi on essaie surtout de regrouper, tant que faire se peut, les composants électroniques bas entre eux et les composants électroniques moyens entre eux.

Le canal contourne de préférence les ouvertures traversantes et/ou les ouvertures non traversantes de la plaque froide ce qui permet de faciliter la fabrication de la plaque froide.

La distance entre le support et le canal est constante, ce qui permet de faciliter la fabrication de la plaque froide.

La plaque froide est de préférence fixée sur le support de façon à ce que les coussinets déformables soient comprimés entre les composants électroniques et la plaque froide. Plus précisément, le support s'étend de préférence selon un plan de référence, la plaque froide s'étendant parallèlement à ce plan de référence. Lorsque le support ne fonctionne pas, et donc qu'elle ne dégage pas de chaleur, la plaque froide est de préférence fixée sur le support de façon à ce qu'une pression perpendiculaire au plan de référence soit exercée sur les coussinets déformables qui sont situés entre les composants électroniques et la plaque froide. Cette pression perpendiculaire au plan de référence permet de compresser les coussinets déformables de façon à s'assurer que quelles que soient les dispersions sur la hauteur des composants issue des process de fabrication et la déformation du support, les composants électroniques restent en contact thermique avec la plaque froide via les coussinets déformables. Pour cela, les coussinets déformables sont de préférence comprimés de façon à présenter une déformation de 20% à 50%. En outre, une telle compression permet à la déformée du support due à la pression exercée sur les coussinets déformables de ne pas être trop importante de façon à rester compatible avec la résistance mécanique du support.

La plaque froide est de préférence fixée sur le support par plusieurs éléments de fixation, répartis sur l'ensemble de la plaque froide de façon à répartir les efforts sur l'ensemble de la plaque froide et sur l'ensemble du support. En outre, le support comporte de préférence des zones de drains thermiques formées par des vias connectant des plans de masses internes du support à des zones conductrices thermiquement en surface du support et sur lesquelles reposent les éléments de fixation de la plaque froide au support ou les coussinets déformables situés entre les éléments de fixation de la plaque froide au support et le support.

Les coussinets déformables présentent de préférence une hauteur comprise entre 1 mm et 5 mm et de manière plus préférentielle entre 1.5 et 3 mm. En effet, on choisit de préférence une hauteur faible pour les coussinets déformables de façon à optimiser le refroidissement des composants électroniques via la plaque froide. En outre, l'épaisseur des coussinets déformables est choisie de façon à pouvoir s'adapter aux variations de hauteur des composants électroniques. Ainsi, une telle épaisseur pour les coussinets leur permet de tolérer des variations de hauteurs des composants électroniques de l'ordre de +/- 0.5 mm.

Les coussinets déformables sont de préférence réalisés en gel silicone avec poudre céramique. L'utilisation de ces matériaux permet d'avoir une bonne conduction thermique, d'avoir des coussinets suffisamment déformable, sans toutefois salir le support.

La plaque froide est de préférence réalisée en aluminium.

La plaque de base est de préférence creusée par un procédé d'usinage de façon à réaliser le canal.

La plaque complémentaire est de préférence fixée à la plaque de base par une méthode de soudage par friction malaxage ou « friction stir welding » en anglais, ce qui d'avoir une fixation très résistante et fiable.

Le canal forme de préférence un circuit hydraulique qui parcourt la plaque froide en contournant les ouvertures traversantes et les ouvertures non traversantes. Plus la longueur du canal est grande, plus le refroidissement de la carte électronique est efficace. La plaque froide est de préférence pourvue d'un connecteur hydraulique d'entrée qui permet d'injecter un fluide caloporteur dans le canal et d'un connecteur hydraulique de sortie, qui permet d'évacuer le fluide caloporteur du canal. Le connecteur hydraulique d'entrée et le connecteur hydraulique de sortie sont de préférence situés côte à côte sur une même face latérale de la plaque froide.

Le support est de préférence formé par un ou plusieurs circuits imprimés. Dans le cas où le support est formé par plusieurs circuits imprimés, ces circuits imprimés sont de préférence situés côte à côte, dans un même plan de référence.

Chaque carte électronique peut en outre comprendre un ou plusieurs circuits imprimés additionnels. Dans ce cas, la plaque froide est de préférence située entre le support et le ou les circuits imprimés additionnels.

En outre, la carte électronique peut également comporter une plaque froide additionnelle située entre la première plaque froide et le ou les circuit(s) imprimé(s) additionnel(s). Cette deuxième plaque froide permet de faciliter la fixation du ou des circuit(s) imprimé(s) additionnel(s) sur la première plaque froide et de faciliter le transfert thermique entre le support et le ou les circuit(s) imprimé(s) additionnel(s).

La plaque froide additionnelle peut également comporter des ouvertures non traversantes et/ou des ouvertures traversantes lorsque le ou les circuit(s) imprimé(s) additionnel(s) sont pourvus de composants électroniques présentant une hauteur supérieure à la distance entre la plaque froide additionnelle et le ou les circuit(s) imprimé(s) additionnel(s).

Un deuxième aspect de l'invention concerne également une lame de calcul comportant une carte électronique selon le premier aspect de l'invention.

Un troisième aspect de l'invention concerne un serveur montable sur bâti comportant au moins une lame de calcul selon le deuxième aspect de l'invention. Un tel serveur montable sur bâti est très avantageux car les différentes lames de calcul sont facilement démontables, avec leurs systèmes de refroidissement.

Le serveur montable sur bâti comporte également de préférence un répartiteur hydraulique (manifold en anglais) permettant d'injecter un fluide caloporteur dans le canal de chaque plaque froide

Un quatrième aspect de l'invention concerne également un bâti ou « rack » en anglais comportant au moins un serveur montable sur bâti selon le troisième aspect de l'invention.

Le bâti ainsi formé est très avantageux car les serveurs montables sur bâti sont aisément démontables avec leur système de refroidissement. En outre, il est compact.

Le bâti comporte de préférence un répartiteur hydraulique principal permettant d'injecter un fluide caloporteur dans des répartiteurs hydrauliques de chaque serveur.

Le bâti comporte également de préférence une pompe permettant d'injecter le fluide caloporteur selon un débit choisi dans les différents canaux des différentes lames de calcul.

### BREVES DESCRIPTIONS DES FIGURES

D'autres caractéristiques et avantages de l'invention ressortiront à la lecture de la description détaillée qui suit, en référence aux figures annexées, qui illustrent :
- La figure 1, une représentation schématique d'un bâti selon un mode de réalisation de l'invention ;
- La figure 2, une représentation schématique d'un serveur montable sur bâti selon un mode de réalisation de l'invention ;
- La figure 3, une représentation schématique d'une carte électronique selon un mode de réalisation de l'invention ;
- La figure 4, une vue de dessus de la carte électronique de la figure 3 ;
- La figure 5, une vue en perspective d'une partie de la carte électronique de la figure 3 ;
- La figure 6, une vue en coupe de la carte électronique de la figure 3 ;
- La figure 7, une vue en perspective d'une plaque froide d'une carte électronique selon un mode de réalisation de l'invention ;
- La figure 8, une vue de dessus de la plaque froide la figure 7 ;
- La figure 9, une vue en coupe d'une section transversale d'une partie de la plaque froide de la figure 8 ;
- La figure 10, une vue en coupe d'une carte électronique selon un mode de réalisation de l'invention.

Pour plus de clarté, les éléments identiques ou similaires sont repérés par des signes de références identiques sur l'ensemble des figures.

### DESCRIPTION DETAILLEE D'AU MOINS UN MODE DE REALISATION

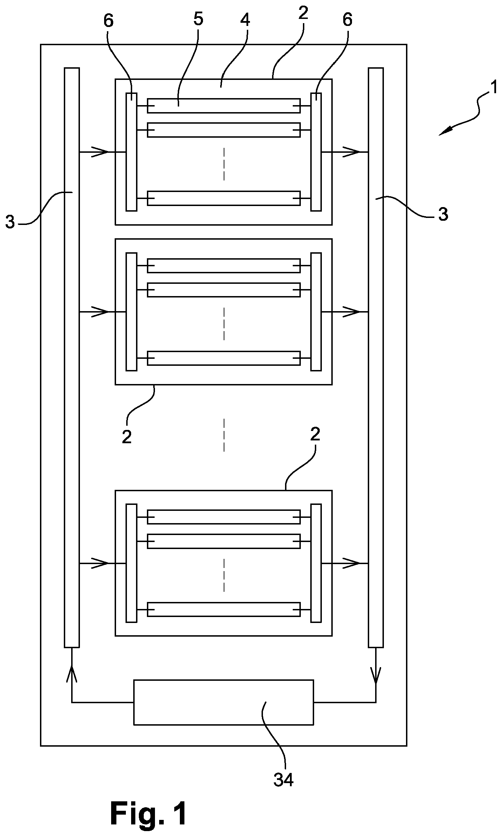

La figure 1 représente un bâti 1, également appelé « rack » en anglais, selon un mode de réalisation de l'invention. Ce bâti comporte des serveurs montables sur bâti 2, également appelés « server chassis » en anglais, qui sont amovibles du bâti 1. Le bâti 1 comporte également un répartiteur hydraulique principal 3 permettant d'injecter un fluide caloporteur dans les systèmes de refroidissement des serveurs montables sur bâti 1. Le répartiteur hydraulique principal 3 permet également de répartir le fluide caloporteur entre les différents systèmes de refroidissement des différents serveurs montables sur bâti 2. Le bâti 1 comporte également des moyens d'injection et de contrôle du fluide caloporteur 34 permettant notamment de contrôler le débit de circulation du fluide caloporteur, ainsi que sa température. Les moyens d'injection et de contrôle du fluide caloporteur peuvent également comprendre des moyens de détection des fuites.

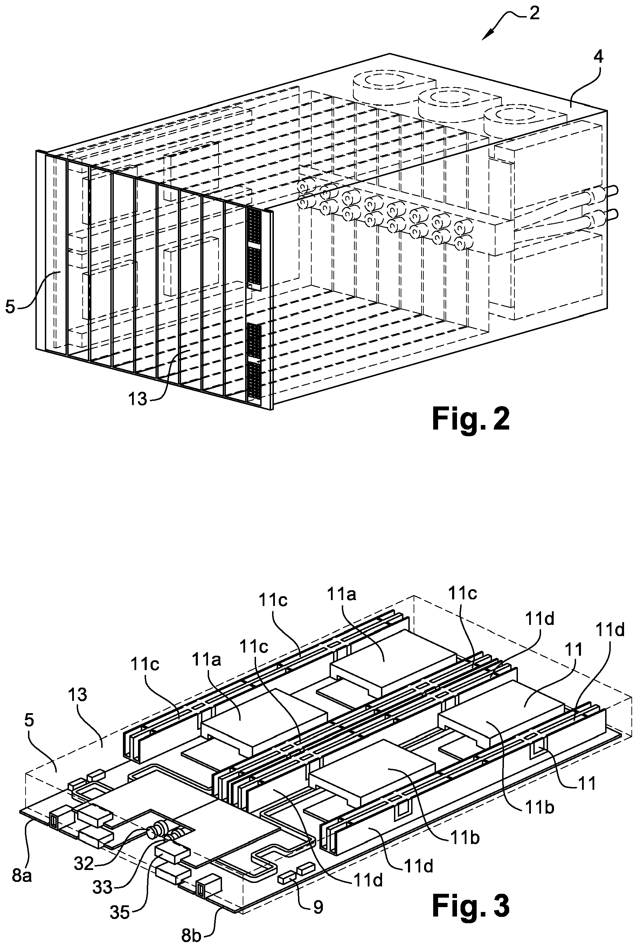

La figure 2 représente un serveur montable sur bâti 2 selon un mode de réalisation de l'invention. Ce serveur montable sur bâti 2 comporte un châssis 4 dans lequel sont montées des lames de calcul 5. Une de ces lames de calcul 5 est représentée plus précisément sur les figures 3 à 5. Chaque serveur montable sur bâti 2 comporte également un répartiteur hydraulique 6 permettant de distribuer le fluide caloporteur entre les systèmes de refroidissement des différentes lames de calcul 5 du serveur montable sur bâti.

La lame de calcul 5 va maintenant être décrite plus en détail en référence aux figures 3 à 9. Cette lame de calcul 5 comporte un cadre 13 renfermant les éléments détaillés ci-après. Ainsi, la lame de calcul 5 comporte à l'intérieur du cadre 13 une carte électronique.

Cette carte électronique comporte un support 7. Ce support 7 est de préférence formé par un ou plusieurs circuits imprimés 8 placés côte à côte. Ainsi, dans ce mode de réalisation, le support 7 comporte deux circuits imprimés 8a, 8b placés côte à côte. Le support 7 s'étend suivant un plan de référence 12 définit par un plan médian au support 7, le plan médian s'étendant parallèlement au support 7. Les deux circuits imprimés 8a, 8b s'étendent également suivant le plan de référence 12.

La carte électronique 5 comporte également des composants électroniques 9, 10, 11 fixés sur le support 7. On appelle hauteur d'un composant sa dimension suivant un axe perpendiculaire au plan de référence.

Les composants électroniques 9, 10, 11 peuvent être de trois sortes :
- Ils peuvent présenter une hauteur h inférieure à une première hauteur seuil h1. Dans ce cas, on appelle ces composants électroniques « composants électroniques bas » 9 ;
- Ils peuvent présenter une hauteur h comprise entre h1 et une deuxième hauteur seuil h2. Dans ce cas, on appelle ces composants électroniques « composants électroniques moyens » 10 ;
- Ils peuvent également présenter une hauteur h supérieure ou égale à la deuxième hauteur seuil h2. Dans ce cas, on appelle ces composants « composants électroniques hauts » 11.

Dans ce mode de réalisation, la carte électronique comporte notamment, comme composants électroniques hauts :
- deux processeurs 11a, 11b fixés sur chaque circuit imprimé 8a, 8b formant le support 7 ;
- des barrettes mémoires 11c, 11d fixés sur chaque circuit imprimé 8a, 8b de part et d'autre de chaque processeur 11a, 11b.

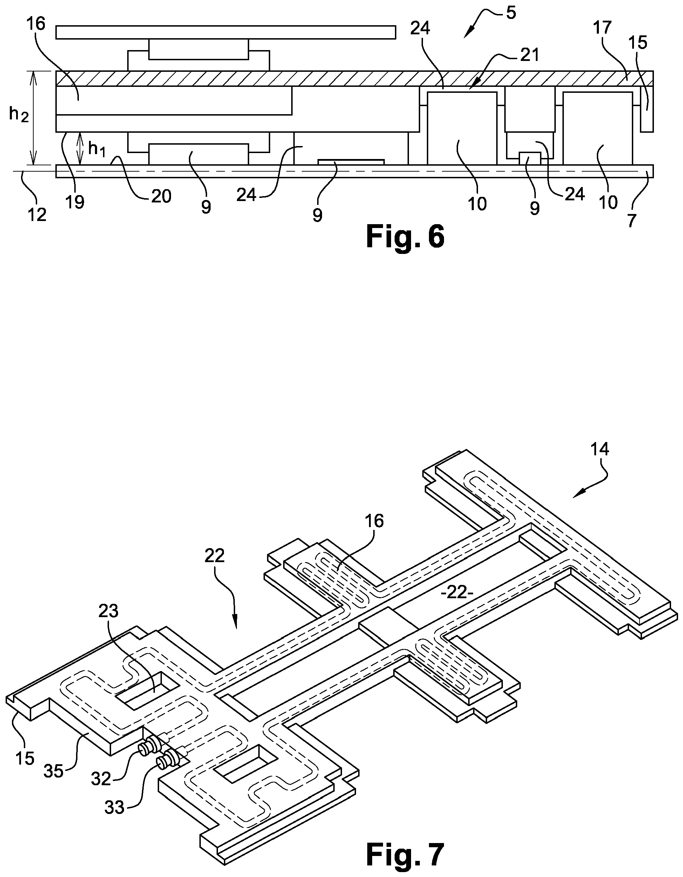

La carte électronique 5 comporte également une plaque froide 14 permettant de refroidir les circuits imprimés 8a, 8b et les composants électroniques 9, 10, 11 lorsqu'ils sont en fonctionnement. La plaque froide 14 est représentée plus précisément sur les figures 6 à 9. La plaque froide 14 comporte :
- une plaque de base 15 dans laquelle est creusé un canal 16 qui forme un circuit hydraulique apte à être parcouru par un fluide caloporteur ;
- une plaque complémentaire 17 qui est fixée sur la plaque de base de façon à fermer le canal 16.

La plaque complémentaire 17 est de préférence fixée sur la plaque de base 15 par un procédé de soudage par friction malaxage ou « friction stir welding ». Toutefois, la plaque complémentaire 17 pourrait être fixée par d'autres procédés de fixation comme le brasage ou encore le soudage laser. La plaque froide 14 est de préférence réalisée en aluminium.

La plaque froide 14 comporte également un connecteur hydraulique d'entrée 32 relié à une première extrémité du canal 16 et un connecteur hydraulique de sortie 33 relié à une deuxième extrémité du canal 16. Le connecteur hydraulique d'entrée 32 et le connecteur hydraulique de sortie 33 sont de préférence situés au niveau d'un même côté 35 de la plaque froide 14. Les connecteurs hydrauliques d'entrée et de sortie sont reliés au répartiteur hydraulique 6 du serveur montable sur bâti 2 auquel appartient la carte électronique 5. Ils permettent d'injecter le fluide caloporteur dans le canal de la plaque froide. Pour cela, le répartiteur hydraulique 6 est relié au répartiteur hydraulique principal 3 du bâti, qui lui-même est relié aux moyens d'injection et de contrôle du fluide caloporteur 34 permettant notamment de contrôler le débit de circulation du fluide caloporteur, ainsi que sa température.

La plaque froide 14 est fixée sur le support 7. La première hauteur seuil h1 est définie par la distance entre la surface inférieure 19 de la plaque froide 14 et la surface supérieure 20 du support 7. La première hauteur h1 est limitée par la hauteur du cadre 13 de la lame de calcul 5. La première hauteur h1 peut par exemple être égale à 3 mm. La deuxième hauteur seuil h2 est définie par la somme de la première hauteur seuil h1 et de l'épaisseur de la plaque froide 14. La deuxième hauteur h2 peut par exemple être égale à 16 mm.

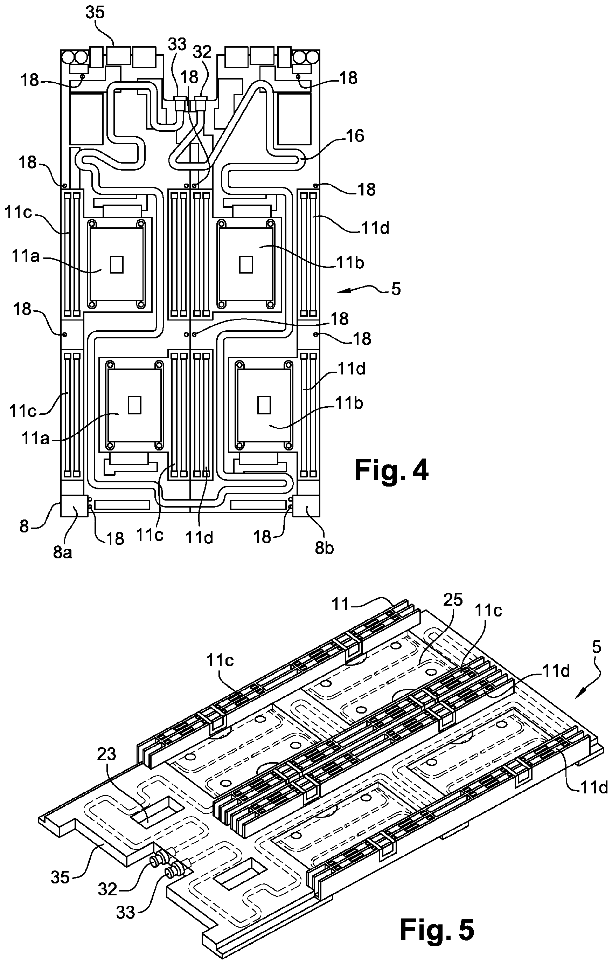

La plaque froide 14 présente des dimensions extérieures sensiblement égales à celles du support 7 comme on peut le voir sur la figure 4 par exemple, de sorte qu'elle recouvre l'ensemble de la surface du support 7, à l'exception des zones dans lequel il y a des composants électroniques hauts, comme on le verra dans la suite.

Ainsi, la plaque froide 14 recouvre tous les composants électroniques bas 9. En outre, des ouvertures non traversantes 21 sont réalisées dans la plaque froide 14 au dessus des composants électroniques moyens 10 de façon à ce que la plaque froide recouvre également les composants électroniques moyens 10.

Les composants électroniques bas 9 et les composants électroniques moyens 10 sont reliés à la plaque froide 14 par l'intermédiaire de coussinets déformables 24 conducteurs thermiquement. Les coussinets déformables 24 permettent d'améliorer l'évacuation de la chaleur des composants électroniques via la plaque froide, sans salir les composants électroniques ou le support. Afin d'optimiser le refroidissement des composants électronique, l'épaisseur des coussinets déformables est de préférence la plus faible possible. En outre, cette épaisseur des coussinets déformables doit pouvoir s'adapter à la variation de hauteur des composants électroniques, qui est généralement de l'ordre de +/-0,5mm. Pour ces raisons, les coussinets déformables 24 présentent de préférence une épaisseur comprise entre entre 1.5 et 3 mm. Les coussinets déformables choisis sont de type « gap pad » car :
- ils peuvent être pré-montés sur la plaque froide.
- ils autorisent plusieurs cycles de montage/démontage sans être remplacés.
- ils sont très déformables et peuvent compenser la variation de hauteur des composants électroniques.
- ils ne polluent ni ne salissent ni le support, ni ses composants.

Ainsi, les coussinets déformables 24 sont de préférence réalisés en gel silicone avec poudre céramique.

En outre, la plaque froide 14 est fixée au support 7 de façon à ce que les coussinets déformables soient compressés, suivant une direction perpendiculaire au plan de référence 12, de 30% environ entre la plaque froide 14 et les composants électroniques 9, 10. Cette compression permet aux coussinets déformables 24 de toujours rester en contact avec la plaque froide 14 et les composants 9, 10 quelles que soient les variations de hauteur des composants électroniques et les tolérances de fabrication. Ainsi, les coussinets déformables permettent de garantir un contact thermique entre la plaque froide et les composants électroniques à refroidir. Toutefois, la déformée du support due à la pression au niveau des coussinets déformables sur les composants électroniques doit rester compatible avec la résistance mécanique du support et ne doit pas rompre le contact entre les autres composants électroniques et les coussinets déformables.

La plaque froide 14 est fixée sur le support 7 par l'intermédiaire d'éléments de fixation 18. Les éléments de fixation 18 ont pour fonction de maîtriser la déformée du support pour les raisons décrites ci-dessus. Pour cela, les éléments de fixation 18 sont répartis sur l'ensemble de la surface du support 7 de façon à répartir les efforts exercés sur le support notamment. Ils permettent en outre d'améliorer le contact thermique entre la plaque froide et le support au niveau des éléments de fixation. Pour cela, des drains de dissipation thermiques sont prévus dans le support au niveau des points de fixation de la plaque froide : ces drains sont de préférence des des vias réalisés dans le support (carte électronique) insérés sous les éléments de fixation de la plaque froide et/ou sous les coussinets déformables reliant le support à la plaque froide de façon à améliorer l'évacuation de la chaleur du support 7 via la plaque froide 14.

Par ailleurs, comme représenté sur la figure 6, le canal 16 contourne les ouvertures non traversantes 21, ce qui permet de simplifier la fabrication de la plaque froide. En effet, le canal présente ainsi une section constante, et il est contenu dans un plan en deux dimensions. La section du canal, sa géométrie et son parcours à travers la plaque froide sont choisis en fonction des composants électroniques à refroidir et de la chaleur qu'ils dégagent. Afin d'optimiser le refroidissement des composants le canal est de préférence situé au plus près de la surface inférieure 19 de la plaque froide, de façon à ce qu'il soit le plus près possible des composants électroniques. En outre, le canal doit passer au-dessus des composants électroniques qui dissipent le plus de chaleur.

En outre, des ouvertures traversantes 22, 23 sont réalisées dans la plaque froide 14 au niveau des composants électroniques hauts 11 de façon à ce que les composants électroniques hauts traversent la plaque froide 14 par ces ouvertures traversantes 22, 23. Comme représenté sur la figure 3, les composants électroniques hauts 11 sont, dans ce mode de réalisation, des processeurs 11a, 11b, des barrettes mémoires 11c, 11d et des connecteurs mezzanines (non représentés) et destinés à être insérés dans les ouvertures traversantes 23. Le fait d'avoir des ouvertures traversantes 22, 23 dans la plaque froide 14 au niveau des composants électroniques hauts permet en outre d'avoir accès aux composants électroniques hauts 11, sans avoir à enlever la plaque froide 14, ce qui permet notamment de pouvoir les réparer ou les changer. Comme représenté sur la figure 7, le canal 16 contourne également les ouvertures traversantes 22,23.

Les composants électroniques hauts ne sont pas toujours suffisamment refroidis par la plaque froide, et par conséquent, la carte électronique peut en outre comprendre des dissipateurs de chaleurs additionnels 25 par exemple situés entre le support 7 et le composant électronique haut à refroidir. Ces dissipateurs de chaleur additionnels comportent par exemple des zones conductrices thermiquement, par exemple en cuivre. Les dissipateurs de chaleur additionnels 25 sont de préférence reliés thermiquement à la plaque froide 14. Cette liaison thermique peut se faire par les éléments de fixation 18 de la plaque froide au support et par les coussinets situés au niveau de ces éléments de fixation 18.

Afin de simplifier la réalisation de la plaque froide 14, les composants électroniques sont de préférence regroupés par taille. En outre, selon l'invention, on privilégie les composants électroniques bas d'une part afin d'avoir le maximum de composants refroidis par la plaque froide et d'autre part afin de simplifier la structure de la plaque froide. En effet, moins il y a de composants électroniques moyens et hauts sur le support, moins il y a d'ouvertures à réaliser dans la plaque froide.

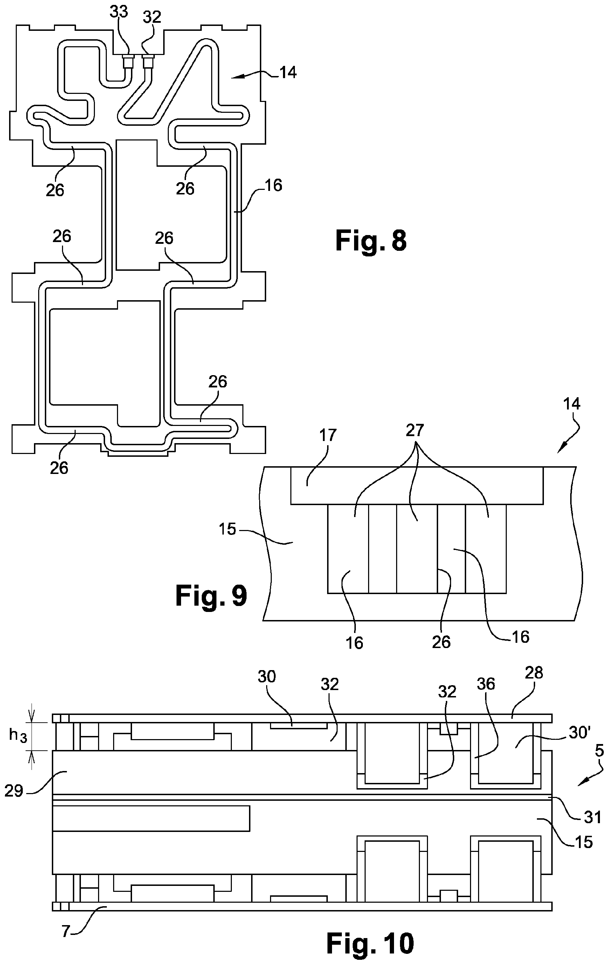

La figure 8 représente un autre mode de réalisation dans lequel le canal comporte des zones de turbulence 26 permettant de créer des turbulences dans le fluide caloporteur de façon à augmenter les échanges thermiques entre la plaque de base 15 de la plaque froide 14 et le fluide caloporteur. Ces zones de turbulences sont de préférence formées par des ailettes 27 qui s'étendent verticalement dans le canal 16.

La figure 9 représente un autre mode de réalisation dans lequel la carte électronique 5 comporte en outre un circuit électronique additionnel 28 qui s'étend parallèlement au support 7. Des composants électroniques additionnels 30 peuvent également être fixés sur le circuit électronique additionnel 28. La carte électronique 5 peut également comporter une plaque froide additionnelle 29 intercalée entre la plaque froide 14 et le circuit électronique additionnel 28. Cette plaque froide additionnelle 29 permet de refroidir les composants 30 fixés sur le circuit électronique additionnel 28 et elle permet en outre de faciliter la fixation du circuit électronique additionnel 28 et de ses composants électroniques 30 à la plaque froide 14, malgré la présence du canal 16 dans la plaque froide 14. La plaque froide additionnelle 29 peut ne pas comporter de canal comme représenté sur la figure 29. La plaque froide additionnelle 29 est fixée sur la plaque froide 14, de préférence par l'intermédiaire d'une interface thermique 31. Les composants électroniques additionnels 30 sont de préférence fixés sur la plaque froide additionnelle 29 par l'intermédiaire de coussinets déformables conducteurs thermiquement 32, qui permettent, comme expliqué précédemment, d'évacuer la chaleur dégagée par les composants électroniques additionnels 30 vers la plaque froide additionnelle 29, et qui permettent en outre de garantir le contact entre la plaque froide additionnelle 29 et les composants thermiques additionnels 28. Lorsque des composants électroniques additionnels 30' présentent une hauteur supérieure à la distance h3 entre la plaque froide additionnelle 29 et le circuit imprimé additionnel 28, la plaque froide additionnelle 29 comprend des ouvertures non traversantes 36 situées dans lesquelles viennent s'insérer lesdits composants 30'.

Naturellement, l'invention n'est pas limitée aux modes de réalisation décrit en référence aux figures et des variantes pourraient être envisagées sans sortir du cadre de l'invention comme revendiqué.

## Revendications

1. Carte électronique (5) comportant :
- un support (7) sur laquelle sont fixés des composants électroniques dits « composants électroniques bas » (9) et des composants électronique dits « composants électroniques hauts », les composants électroniques bas (9) présentant une hauteur inférieure à une première hauteur seuil h1, les composants électroniques hauts présentant une hauteur supérieure à une deuxième hauteur seuil h2 ;
- une plaque froide (14) qui s'étend parallèlement au support (7), la distance entre la plaque froide (14) et le support (7) étant égale à la première hauteur seuil h1, la plaque froide (14) comportant une plaque de base (15) dans laquelle est creusé au moins un canal (16) apte à être parcouru par un fluide caloporteur, la plaque de base (15) étant solidaire d'une plaque complémentaire (17) fermant le canal (16), la plaque froide (14) recouvrant tous les composants électroniques bas (9), les composants électroniques bas (9) étant reliés à la plaque froide (14) par l'intermédiaire de coussinets déformables (24) en matériau conducteur thermiquement, la plaque froide (14) étant percée par des ouvertures traversantes (22, 23) dans lesquelles sont insérés les composants électroniques hauts (11),
- des dissipateurs de chaleurs additionnels (25) reliant thermiquement les composants électroniques hauts (11) et la plaque froide (14).

2. Carte électronique (5) selon la revendication précédente, **caractérisée en ce que** la plaque froide (14) présente des dimensions extérieures égales à celles du support (7).

3. Carte électronique (5) selon l'une des revendications précédentes, **caractérisée en ce que** la carte électronique (5) comporte des composants électroniques dits « composants électroniques moyens » (10) présentant une hauteur comprise entre la première hauteur seuil h1 et une deuxième hauteur seuil h2 supérieure à h1, les composants électroniques moyens (10) étant fixés sur le support (7), la plaque froide (14) étant percée par des ouvertures non traversantes (21) dans lesquelles sont insérés les composants électroniques moyens (10), les composants électroniques moyens (10) étant reliés à la plaque froide (14) par l'intermédiaire de coussinets déformables (24) en matériau conducteur thermiquement.

4. Carte électronique (5) selon l'une des revendications précédentes, dans laquelle le canal (16) contourne les ouvertures traversantes (22, 23) et/ou les ouvertures non traversantes(21) de la plaque froide (14).

5. Carte électronique (5) selon l'une des revendications précédentes, dans laquelle la distance entre le support (7) et le canal (16) est constante.

6. Carte électronique (5) selon l'une des revendications précédentes, dans laquelle la plaque froide (14) est fixée sur le support (7) de façon à ce que les coussinets déformables (24) soient comprimés entre les composants électroniques (9, 10) et la plaque froide (14).

7. Carte électronique (5) selon l'une des revendications précédentes, comportant en outre un ou plusieurs circuits imprimés additionnels (28), la plaque froide (14) étant située entre le support (7) et le ou les circuits imprimés additionnels (28), la carte électronique (5) comportant en outre une plaque froide additionnelle (29) située entre la plaque froide (14) et le ou les circuit(s) imprimé(s) additionnel(s) (28).

8. Serveur montable sur bâti (2) comportant une carte électronique (5) selon l'une des revendications précédentes.

## Patentansprüche

1. Elektronische Karte (5), die Folgendes umfasst:
- einen Träger (7), an dem "niedrige elektronische Komponenten" (9) genannte elektronische Komponenten und "hohe elektronische Komponenten" genannte elektronische Komponenten befestigt sind, wobei die niedrigen elektronischen Komponenten (9) eine Höhe haben, die unter einer ersten Grenzhöhe h1 liegt, und die hohen elektronischen Komponenten eine Höhe haben, die über einer zweiten Grenzhöhe h2 liegt,
- eine Kühlplatte (14), die sich parallel zum Träger (7) erstreckt, wobei der Abstand zwischen der Kühlplatte (14) und dem Träger (7) der ersten Grenzhöhe h1 entspricht, die Kühlplatte (14) eine Grundplatte (15) umfasst, in der mindestens ein Kanal (16) gegraben ist, durch den ein Wärmeübertragungsfluid strömen kann, die Grundplatte (15) mit einer den Kanal (16) schließenden komplementären Platte (17) fest verbunden ist, die Kühlplatte (14) alle niedrigen elektronischen Komponenten (9) bedeckt, die niedrigen elektronischen Komponenten (9) über verformbare Lager (24) aus wärmeleitendem Material mit der Kühlplatte (14) verbunden sind und die Kühlplatte (14) mit Durchgangsöffnungen (22, 23) durchbohrt ist, in die die hohen elektronischen Komponenten (11) eingesetzt sind,
- Zusatzwärmeableiter (25), die die hohen elektronischen Komponenten (11) und die Kühlplatte (14) thermisch verbinden.

2. Elektronische Karte (5) nach dem vorhergehenden Anspruch, **dadurch gekennzeichnet, dass** die Kühlplatte (14) Außenabmessungen hat, die denjenigen des Trägers (7) entsprechen.

3. Elektronische Karte (5) nach einem der vorhergehenden Ansprüche, **dadurch gekennzeichnet, dass** die elektronische Karte (5) "mittlere elektronische Komponenten" (10) genannte elektronische Komponenten mit einer Höhe zwischen der ersten Grenzhöhe h1 und einer zweiten Grenzhöhe h2, die über h1 liegt, aufweist, wobei die mittleren elektronischen Komponenten (10) am Träger (7) befestigt sind, die Kühlplatte (14) mit nicht durchgehenden Öffnungen (21) durchbohrt ist, in die die mittleren elektronischen Komponenten (10) eingesetzt sind, und die mittleren elektronischen Komponenten (10) über verformbare Lager (24) aus wärmeleitendem Material mit der Kühlplatte (14) verbunden sind.

4. Elektronische Karte (5) nach einem der vorhergehenden Ansprüche, bei der der Kanal (16) die Durchgangsöffnungen (22, 23) und/oder die nicht durchgehenden Öffnungen (21) der Kühlplatte (14) umgeht.

5. Elektronische Karte (5) nach einem der vorhergehenden Ansprüche, bei der der Abstand zwischen dem Träger (7) und dem Kanal (16) konstant ist.

6. Elektronische Karte (5) nach einem der vorhergehenden Ansprüche, bei der die Kühlplatte (14) am Träger (7) befestigt ist, so dass die verformbaren Lager (24) zwischen den elektronischen Komponenten (9, 10) und der Kühlplatte (14) zusammengedrückt sind.

7. Elektronische Karte (5) nach einem der vorhergehenden Ansprüche, mit einem oder mehreren zusätzlichen Leiterplatten (28), wobei die Kühlplatte (14) zwischen dem Träger (7) und der oder den zusätzlichen Leiterplatte(n) (28) angeordnet ist, wobei die elektronische Karte (5) ferner eine zusätzliche Kühlplatte (29) aufweist, die zwischen der Kühlplatte (14) und der oder den zusätzlichen Leiterplatte(n) (28) angeordnet ist.

8. Server, der für den Gestelleinbau (2) geeignet ist, mit einer elektronischen Karte (5) nach einem der vorhergehenden Ansprüche.

## Claims

1. An electronic board (5) comprising:
a support (7) on which are fixed electronic components referred to as "low electronic components" (9) and electronic components referred to as "high electronic components", the low electronic components (9) having a height of less than a first threshold height h1, the high electronic components having a height greater than a second threshold height h2;
- a cold plate (14) that extends parallel to the support (7), the distance between the cold plate (14) and the support (7) being equal to the first threshold height h1, the cold plate (14) comprising a base plate (15) in which at least one channel (16) is formed through which a coolant is able to circulate, the base plate (15) being fixed to a complementary plate (17) closing the channel (16), the cold plate (14) covering all the electronic components (9), the low electronic components (9) being connected to the cold plate (14) through deformable pads (24) made of a heat conducting material, the cold plate (14) being pierced by through openings (22,23) in which the high electronic components (11) are inserted,
- additional heat dissipaters (25) thermally connecting the high electronic components (11) and the cold plate (14).

2. The electronic board (5) according to the preceding claim, **characterized in that** the cold plate (14) has outside dimensions equal to the support dimensions (7).

3. The electronic board (5) according to one of the preceding claims, **characterized in that** the electronic board (5) comprises electronic components referred to as "medium electronic components" (10) having a height between the first threshold height h1 and a second threshold height h2 greater than h1, the medium electronic components (10) being fixed to the support (7), the cold plate (14) being pierced by non-through openings (21) in which the medium electronic components (10) are inserted, the medium electronic components (10) being connected to the cold plate (14) through deformable pads (24) made of a heat conducting material.

4. The electronic board (5) according to one of the preceding claims, wherein the channel (16) goes around the through openings (22, 23) and/or the non-through openings (21) of the cold plate (14).

5. The electronic board (5) according to one of the preceding claims, wherein the distance between the support (7) and the channel (16) is constant.

6. The electronic board (5) according to one of the preceding claims, wherein the cold plate (14) is fixed to the support (7) such that the deformable pads (24) are compressed between the electronic components (9, 10) and the cold plate (14).

7. The electronic board (5) according to one of the preceding claims further comprising one or several additional printed circuits (28), the cold plate (14) being located between the support (7) and the additional printed circuit(s) (28), the electronic board (5) further comprising an additional cold plate (29) located between the cold plate (14) and the additional printed circuit(s) (28).

8. A rackable server (2) comprising an electronic board (5) according to one of the preceding claims.
